**Europäisches Patentamt**

**European Patent Office**

**Office européen des brevets**

(19)

(11) Veröffentlichungsnummer: **0 185 186**
**B1**

(12) # EUROPÄISCHE PATENTSCHRIFT

(45) Veröffentlichungstag der Patentschrift:
**01.02.89**

(51) Int. Cl.⁴: **G01R 33/022**

(21) Anmeldenummer: **85114148.1**

(22) Anmeldetag: **06.11.85**

(54) **Verfahren zur Herstellung eines dreidimensionalen Gradiometers für eine Vorrichtung zur ein- oder mehrkanaligen Messung schwacher Magnetfelder.**

(30) Priorität: **19.11.84 DE 3442237**

(43) Veröffentlichungstag der Anmeldung:
**25.06.86 Patentblatt 86/26**

(45) Bekanntmachung des Hinweises auf die Patenterteilung:
**01.02.89 Patentblatt 89/5**

(84) Benannte Vertragsstaaten:
**DE FR NL**

(56) Entgegenhaltungen:
**US-A- 4 280 095**

(73) Patentinhaber: **Siemens Aktiengesellschaft Berlin und München, Wittelsbacherplatz 2, D-8000 München 2(DE)**

(72) Erfinder: **Hoenig, H. Eckhardt, Dr., Palmstrasse 1a, D-8520 Erlangen(DE)**

**Beschreibung**

Die Erfindung bezieht sich auf ein Verfahren zur Herstellung eines Gradiometers mit dreidimensionaler Struktur für eine ein- oder mehrkanalige Vorrichtung zur Messung von Magnetfeldern mit Feldstärken bis unter $10^{-10}$ T, insbesondere unter $10^{-12}$ T, bei dem die in verschiedenen Ebenen liegenden supraleitenden Gradiometerspulen vorbestimmter Abmessungen über supraleitende Verbindungsleitungen untereinander verbunden und an mindestens ein supraleitendes Quanten-Interferenz-Element (SQUID) angekoppelt werden. Ein derartiges Verfahren geht aus der DE-A 3 247 543 hervor.

Die Verwendung von supraleitenden Quanten-Interferenz-Elementen, die allgemein als "SQUIDs" (Abkürzung von "Superconducting QUantum Interference Devices") bezeichnet werden, zur Messung sehr schwacher magnetischer Felder ist allgemein bekannt (J. Phys. E: Sci. Instrum.", Vol. 13, 1980, Seiten 801 bis 813; "IEEE Transactions on Electron Devices", Vol. ED-27, No. 10, Oktober 1980, Seiten 1896 bis 1908). Als ein bevorzugtes Anwendungsgebiet für diese Elemente wird deshalb auch die medizinische Technik, insbesondere die Magnetokardiographie und Magnetoenzephalographie angesehen, wobei magnetische Herz- bzw. Gehirnwellen mit Feldstärken in der Größenordnung von 50 pT bzw. 0,1 pT auftreten ("Biomagnetism – Proceedings Third International Workshop on Biomagnetism, Berlin 1980", Berlin/New York 1981, Seiten 3 bis 31; "Review of Scientific Instruments", Vol. 53, No. 12, Dez. 1982, Seiten 1815 bis 1845).

Eine Vorrichtung zur Messung derartiger biomagnetischer Felder enthält im wesentlichen folgende Komponenten:

1. Ein SQUID als den eigentlichen Feld-Sensor mit einem sogenannten Gradiometer,
2. einen Flußtransformator in Form einer Spulenanordnung zur Einkopplung des zu untersuchenden Feldes in das SQUID,
3. elektronische Geräte zur Signalerfassung und -verarbeitung,
4. Abschirmungen für das magnetische Erdfeld und externe Störfelder und
5. ein Kryosystem zur Gewährleistung der Supraleitung von Sensor und Gradiometer.

Der Aufbau und die Funktionsweise entsprechender einkanalig ausgebildeter Vorrichtungen ist bekannt. Bei diesen Vorrichtungen wird das nachzuweisende Magnetfeld, das bis zu 6 Größenordnungen kleiner als externe Störfelder ist, im allgemeinen über eine dreidimensionale Spulenanordnung in den von einem Radiofrequenz (RF)-SQUID gebildeten Kreis mit einem Josephson-Kontakt induktiv eingekoppelt. Dabei sind durch Kombination einer Sensorspule – auch Detektionsspule genannt – mit einer oder mehreren Kompensationsspulen als Gradiometer erster bzw. höherer Ordnung bezeichnete Spulensysteme ausgebildet. Mit solchen Gradiometern können bei entsprechendem manuellen Abgleich die drei Komponenten eines im Spulenbereich homogenen Magnetfeldes bzw. auch dessen Anteil mit homogenem Gradienten weitgehend unterdrückt und das im Gradiometerbereich noch stark inhomogene biomagnetische Nahfeld selektiv erfaßt werden.

Um mit einer derartigen Vorrichtung eine räumliche Feldverteilung zu erhalten, muß zeitlich nacheinander an verschiedenen Orten des zu untersuchenden Bereiches gemessen werden. Hierbei ergibt sich aber die Schwierigkeit, daß über die hierfür erforderliche Meßzeit die Kohärenz der Felddaten nicht mehr gegeben ist und sich außerdem klinisch unzumutbare Meßzeiten ergeben. Es ist deshalb vorgeschlagen worden, statt der bekannten einkanaligen Messung eine mehrkanalige vorzunehmen (vgl. z.B. "Physica", Vol. 107B, 1981, Seiten 29 und 30). Hierbei weist jeder Kanal neben einem RF-SQUID ein abstimmbares supraleitendes Gradiometer auf, dessen Spulen über Verbindungsleitungen und eine auch als Koppeltransformator bezeichnete Koppelspule an das SQUID angekoppelt sind. Bei einer entsprechenden Vorrichtung ergibt sich jedoch ein erheblicher, zeitraubender Aufwand hinsichtlich der Abstimmung der einzelnen Kanäle aufeinander. Bei dieser Vorrichtung sind nämlich das Gradiometer einerseits und das SQUID mit seiner Koppelspule andererseits jeweils auf einem eigenen Trägerkörper angeordnet, wobei diese Teile über lösbare Verbindungsleitungen aneinander anzuschließen sind. Mit einer derartigen Verbidungstechnik läßt sich jedoch eine konstante Abstimmung des jeweiligen Flußtransformators nicht von vornherein gewährleisten. Vielmehr ist vor jeder Messung ein Abgleich aller Kanäle erforderlich, die sich auch untereinander beeinflussen. Außerdem ist bei einer solchen Anordnung eine gegenseitige Störung der RF-Kreise unvermeidlich. Die gegenseitige Störung der Kanäle bei benachbarter Anordnung sowie das Eigenrauschen der Einzelkanäle kann zwar durch die Verwendung von Gleichstrom(DC)-SQUIDs an Stelle von RF-SQUIDs reduziert werden (vgl. z.B. "IEEE Transactions on Magnetics", Vol. MAG-19, No. 3, Mai 1983, Seiten 835 bis 844). Jedoch ist auch hier der Abgleich der Einzelkanäle eines entsprechenden, modular aufgebauten Vielkanal-Gradiometer-Systems schwer zu beherrschen.

Die dreidimensional strukturierten Gradiometer der bekannten Vorrichtungen werden im allgemeinen aus supraleitendem Draht auf entsprechenden Wickelkörpern angefertigt, wobei herstellungsbedingte Abgleichtoleranzen von etwa $10^{-3}$ kaum zu unterschreiten sind. Eine Verbesserung dieser Toleranzen wird durch einen nachträglichen mechanischen Abgleich erreicht. Mit diesem Verfahren ist jedoch eine Realisierung von komplexen Gradiometer-Reihen, auch Gradiometer-Feldern (Arrays) genannt, wie sie für mehrkanalige Meßvorrichtungen erforderlich sind, nur schwer zu erreichen, da ein mechanischer Abgleich bei derartigen Vorrichtungen praktisch nicht durchzuführen ist.

Aus der eingangs genannten DE-A 3 247 543 ist darüber hinaus bekannt, derartige Gradiometer-Reihen in Dünnfilm-Planartechnik zu erstellen. Gemäß diesem bekannten Verfahren werden zunächst die zu jedem Gradiometer gehörenden Spulen in ver-

schiedenen Ebenen eines dreidimensionalen Substratkörpers in der genannten Technik aufgebracht. Diese Spulen müssen dann untereinander und mit dem (den) SQUID(s) über besondere Verbindungsleitungen verknüpft werden (Figuren 5 bis 7). Die bekannte Dünnfilm-Technik erlaubt zwar einen besseren Abgleich als auch die Realisierung komplexerer Strukturen. Die hierfür erforderliche supraleitende Verbindungstechnik ist jedoch sehr aufwendig. Es wird auch auf die US-A 4 280 095 hingewiesen, laut der ein dreidimensionaler Gradiometer durch selektives Ausfräsen und Bedampfen (u.U. mehrfach hintereinander) eines zylindrischen Körpers hergestellt wird.

Aufgabe der vorliegenden Erfindung ist es deshalb, das eingangs genannte Verfahren derart auszugestalten, daß mit ihm ein- oder mehrkanalige Meßvorrichtungen mit dreidimensionalen Gradiometern herzustellen sind, deren Verbindungsleitungen auf einfache Weise ausgebildet werden können.

Diese Aufgabe wird erfindungsgemäß mit den im Hauptanspruch angegebenen Maßnahmen gelöst.

Die mit dem erfindungsgemäßen Verfahren verbundenen Vorteile sind insbesondere darin zu sehen, daß die Gradiometerspulen zusammen mit den zugeordneten Verbindungsleitungen ohne größere Schwierigkeiten in Dünn- oder Dickfilmtechnik als zunächst planare Struktur auszubilden sind. Durch eine geeignete Verformungs- oder Faltungstechnik, wobei vorbestimmte Schnitte in den noch ebenen Substratkörper zu legen sind, läßt sich dann ohne weiteres die gewünschte dreidimensionale Struktur erhalten. Eine nachträgliche aufwendige Verbindungstechnik zwischen den einzelnen Spulen ist dabei vorteilhaft vermieden. Außerdem wird dadurch auch der Abgleich dementsprechend vereinfacht.

Vorteilhafte Weiterbildungen des erfindungsgemäßen Verfahrens gehen aus den Unteransprüchen hervor.

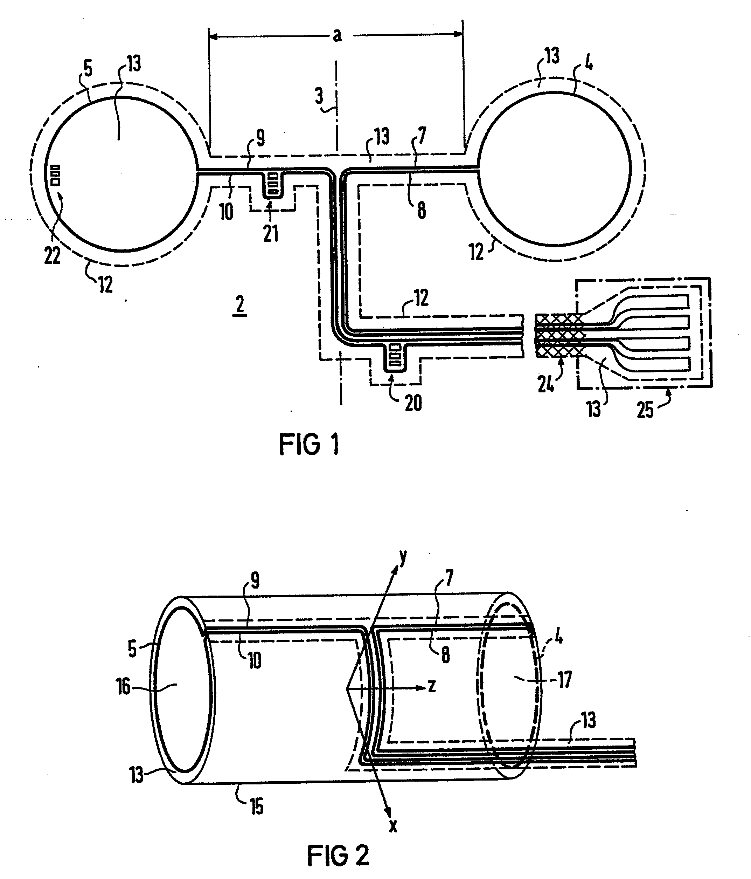

Zur weiteren Erläuterung der Erfindung wird nachfolgend auf die Zeichnung Bezug genommen, in deren Figuren 1 und 2 jeweils ein Verfahrensschritt zur erfindungsgemäßen Herstellung eines Gradiometers veranschaulicht ist.

Gemäß der in Figur 1 schematisch gezeigten Aufsicht auf einen ebenen, hinreichend verformbaren bzw. flexiblen Substratkörper 2 wird zunächst die gesamte Struktur eines Gradiometers oder einer Gradiometer-Reihe (Arrays) einschließlich der erforderlichen Zu- und Verbindungsleitungen in an sich bekannter Weise als Dünn- oder Dickfilm-Struktur erzeugt. Hierzu werden vorzugsweise die Leiterbahnen mit den für insbesondere doppelseitige durchkontaktierte flexible Schaltungen bekannten Methoden durch Ätzen von Manganin oder möglichst hochohmiger Bronze auf einem Polyimid-Substratkörper 2 und anschließendes Verbleien, z.B. mit einer Sn-Pb-Legierung, hergestellt (vgl. Druckschrift der Fa. C. Freudenberg-Simrit/Electronic Components, D-6940 Weinheim, mit dem Titel: "Flexible gedruckte Schaltungen"; oder Druckschrift der Fa. A. Krempel Soehne, D-7000 Stuttgart, mit dem Titel: "Flexible Basismaterialien für flexible gedruckte Schaltungen"). Daneben können in ein bis zwei, gegebenenfalls im Fall der Dünnfilmtechnik auch in mehreren Lithographieebenen die einzelnen Leiterbahnen z.B. durch Sputtern des supraleitenden Materials wie Niob und anschließendes Plasmaätzen ausgebildet werden. Für diese Technik muß der Substratkörper 2 aus einem hinreichend hitzebeständigen Material bestehen. Besonders geeignet sind dünne Polyimid-Folien wie z.B. aus Kapton (eingetragenes Warenzeichen der Firma DuPont).

Da gemäß dem gewählten Ausführungsbeispiel die Herstellung eines axialen Gradiometers erster Ordnung mit symmetrischem Aufbau angenommen ist, werden auf der Flachseite des folienartigen Substratkörpers 2 zwei symmetrisch bezüglich einer Symmetrielinie oder -ebene 3 liegende Gradiometerspulen 4 und 5 in vorbestimmtem Abstand a zueinander ausgebildet. An den der Symmetrieebene 3 zugewandten Seiten gehen die Gradiometerspulen in Verbindungsleitungen 7 und 8 bzw. 9 und 10 über, die zunächst senkrecht auf die Symmetrieebene 3 zugeführt und dort ein Stück untereinander und zu der Symmetrieebene parallel aus dem Bereich der Gradiometerspulen 4 und 5 herausgeführt sind.

Wie in Figur 1 ferner angedeutet sein soll, wird die noch ebene Substratfolie 2 mit die vorbestimmte dreidimensionale Formgebung erleichternden bzw. ermöglichenden Schlitzen oder Schnitten versehen. Dementsprechend kann man nach Erstellung der einzelnen Leiterbahnen einen von einer gestrichelten Linie 12 umrandeten Bereich, der diese Leiterbahnen trägt, aus der flexiblen Substratfolie 2 herausschneiden. Dieser mit 13 bezeichnete Bereich wird anschließend gemäß der in Figur 2 wiedergegebenen schematischen Schrägansicht auf einen geeigneten Trägerkörper aufgeklebt, der insbesondere aus einem besonderen glasartigen oder keramischen Material wie z.B. aus Macor (eingetragenes Warenzeichen der Firma E+P FIBER OPTIC AG, CH-8957 Spreitenbach) bestehen kann. Dabei müssen das Material des Klebstoffes sowie der Substratfolie, die Foliendicke und die Rauhigkeit von Folie und Trägerkörper so aufeinander abgestimmt sein, daß Zugspannungen der Folie bei einer späteren Abkühlung des Gradiometers für den Betriebsfall nicht zu deren Abriß führen.

Für das gewählte Beispiel eines axialen Gradiometers erster Ordnung hat der Trägerkörper 15 zylinderförmige oder auch quaderförmige Gestalt mit planparallelen, um die Größe a beabstandeten Stirnflächen 16 und 17 und mit abgerundeten Kanten. Die Verbindungsleitungen werden dann über diese Kanten zu einem getrennt angeordneten, in der Figur nicht ausgeführten SQUID sowie zwischen den verschiedenen Gradiometerebenen auf diese Weise geführt. Die Verbindungsleitungen sind hierfür hinreichend flexibel.

Eine geeignete Führung und Gestaltung der Verbindungsleiterbahnen erlaubt einen nachträglichen Laser-Abgleich bezüglich der x- und y-Komponenten des mit dem Gradiometer zu detektierenden Magnetfeldes. Der z-Abgleich des Gradiometers kann an der Stirnseite vorgenommen werden. Dabei ist angenommen, daß die z-Achse eines entsprechenden, in Figur 2 eingetragenen x-y-z-Koordinatensystems mit der Zylinderachse des Trägerkörpers 15 übereinstimmt, während die x- und y-Achsen eine Mittelebene aufspannen, in der die Symmetrieebene 3 gemäß Figur 1 liegt. Als Abgleichstellen kann jeweils für eine x-, y-und z-Kompensation eine Mehrzahl von Ringstrukturen 20 bzw. 21 bzw. 22 abgestufter Größe innerhalb der stirnseitigen Schleife der Gradiometerspule 5 bzw. zwischen den entsprechenden Hin- und Rückleitungen 9 und 10 vorgesehen werden (vgl. Figur 1). Diese Ringstrukturen können dann nach Kontrollmessungen, soweit erforderlich, durchtrennt werden. Falls erforderlich, können die Abgleich-Ringstrukturen mittels verhältnismäßig präziser Lithographie auf einer getrennten Substratfolie erzeugt werden, die dann mit der Gradiometerfolie verklebt wird.

Die flexiblen Verbindungsleitungen vom Gradiometerblock zum SQUID können vorteilhaft zum Zweck der Abschirmung als beidseitige Streifenleitung ausgebildet werden. Hierbei sind entsprechende Verzweigungen der sich so ergebenden Streifenleitungsbündel erforderlich. Alternativ können diese Verbindungsleitungen zum Zweck der Abschirmung auch in geeigneter Entfernung von dem Gradiometerblock mit einer supraleitenden Schicht 24 überzogen werden. Das SQUID selbst wird vorteilhaft in einer eigenen supraleitenden Abschirmung 25 angeordnet, die in der Figur durch eine gestrichelte Linie angedeutet ist und die bis auf einen möglichst schmalen und dünnen Einführschlitz für die flexiblen Verbindungsleitungen 7 bis 10 hermetisch verschlossen ist. Innerhalb dieser Abschirmung 25 sind die flexiblen Verbindungsleitungen zweckmäßig verbreitert und z.B. über Nb-Preßkontakte mit dem SQUID verbunden.

Im Falle von verbleiten Manganin- oder Bronze-Leiterbahnen kann vorteilhaft ein verbleiter Bronze-Draht auf die jeweilige Leiterbahn aufgelötet werden, der seinerseits durch einen Crimp-Kontakt mit einem Nb-Draht supraleitend verbunden wird. Dieser Nb-Draht kann durch Punktschweißen mit einer Nb-Kontaktfeder verbunden sein. Es ergibt sich so der Vorteil, daß beim Austausch des Gradiometers dann lediglich Lötungen vorzunehmen sind.

Die gemäß den Figuren 1 und 2 auszubildenden Gradiometer erster Ordnung sind stapelbar, wodurch sich auch Gradiometer zweiter Ordnung kombinieren lassen. Auch planare Gradiometer erster Ordnung lassen sich in gleicher Weise durch Realisierung von zwei Ebenen zu Gradiometern zweiter Ordnung vom gemischten Axial/ Planar-Typ kombinieren. Gradiometer-Reihen lassen sich entsprechend ausbilden.

Falls Leitungsüberkreuzungen in einer zweiten Lithographieebene erzeugt werden sollen, kann der Bereich dieser Überkreuzungen vorteilhaft an einer Stelle zusammengefaßt werden, die bei dem erfindungsgemäßen Verfahren nicht gekrümmt zu werden brauchen. Eine zusätzliche Verstärkung dieser Stelle z.B. durch eine Polyimid-Schicht ist zweckmäßig.

## Patentansprüche

1. Verfahren zur Herstellung eines Gradiometers mit dreidimensionaler Struktur für eine ein- oder mehrkanalige Vorrichtung zur Messung von Magnetfeldern mit Feldstärken bis unter $10^{-10}$ T, insbesondere unter $10^{-12}$ T, bei dem die in verschiedenen Ebenen liegenden supraleitenden Gradiometerspulen (4, 5) vorbestimmter Abmessungen über supraleitende Verbindungsleitungen (7 bis 10) untereinander verbunden und an mindestens ein supraleitendes Quanten-Interferenz-Element (SQUID) angekoppelt werden, dadurch gekennzeichnet, daß zunächst die Gradiometerspulen (4,5) in beabstandeter Lage mit den dazwischen verlaufenden Verbindungsleitungen (7 bis 10) auf einen zumindest weitgehend ebenen, flexiblen Substratkörper (2) aufgebracht werden und daß dann der Substratkörper (2) derart gebogen wird, daß die dreidimensionale Gradiometerstruktur erhalten wird.

2. Verfahren nach Anspruch 1, dadurch gekennzeichnet, daß ein Substratkörper (2) aus einer Folie vorgesehen wird, die mit den Gradiometerspulen (4, 5) und den Verbindungsleitungen (7 bis 10) auf einen Trägerkörper (15) mit einer der dreidimensionalen Gradiometerstruktur angepaßten Gestalt aufgebracht wird.

3. Verfahren nach Anspruch 2, dadurch gekennzeichnet, daß die Leiterbahnen der Gradiometerspulen (4, 5) und der Verbindungsleitungen (7 bis 10) auf einer Folie (2) ausgebildet werden.

4. Verfahren nach Anspruch 3, dadurch gekennzeichnet, daß eine Folie (2) aus einem hitzebeständigen Material vorgesehen wird.

5. Verfahren nach Anspruch 3 oder 4, dadurch gekennzeichnet, daß eine Folie (2) vorgesehen wird, die den Bearbeitungsschritten flexibler Schaltungen unterworfen werden kann.

6. Verfahren nach einem der Ansprüche 3 bis 5, dadurch gekennzeichnet, daß eine dünne Polyimid-Folie als Substratkörper (2) vorgesehen wird.

7. Verfahren nach einem der Ansprüche 1 bis 6, dadurch gekennzeichnet, daß der Substratkörper (2) mit die vorbestimmte Formgebung erleichternden bzw. ermöglichenden Schlitzen oder Schnitten (12) versehen wird.

8. Verfahren nach einem der Ansprüche 1 bis 7, dadurch gekennzeichnet, daß bis auf die die Leiterbahnen der Gradiometerspulen (4, 5) und der Verbindungsleitungen (7 bis 12) tragenden Bereiche (13) die übrigen Bereiche des Substratkörpers (2) vor dem vorbestimmten Formgebungsschritt entfernt werden.

## Claims

1.1. Process for producing a gradiometer, having a three-dimensional structure, for a single or multichanneled device for the measurement of magnetic fields with field strengths in the range below $10^{-10}$ T, more particularly below $10^{-10}$ T, whereby the superconducting gradiometer coils (4, 5) of predetermined dimensions, lying in various planes, are linked together by way of superconducting connecting lines (7 to 10), and are coupled into at least one superconducting quantum-interference-element (SQUID), characterized in that in the first instance the gradiometer coils (4, 5), in such a position that they are spaced apart, with the connecting lines (7 to 10) running between them, are applied to a substrate body (2) which is at least to a large extent level and flexible, and that then, the substrate body (2) is bent in such a way that the three-dimensional gradiometer structure is obtained.

2. Process according to claim 1, characterized in that a substrate body (2) is provided, consisting of a foil which is applied, together with the gradiometer coils (4, 5) and the connecting lines (7 to 10), to a carrier body (15), having a shape matching the three-dimensional gradiometer structure.

3. Process according to claim 2, characterized in that the conductors of the gradiometer coils (4, 5) and those of the connecting lines (7 to 10) are developed on a foil (2).

4. Process according to claim 3, characterized in that a foil (2) of a heat-resistant material, is provided.

5. Process according to claims 3 or 4, characterized in that a foil (2) is provided which can be subjected to the processing steps of flexible circuits.

6. Process according to one of the claims 3 to 5, characterized in that a thin polyimide-foil is provided as a substrate body (2).

7. Process according to one of the claims 1 to 6, characterized in that the substrate body (2) is provided with slits or cuts (12), facilitating or enabling the predetermined shaping.

8. Process according to one of the claims 1 to 7, characterized in that, apart from the areas (13) which carry the conductors of the gradiometer coils (4, 5) and those of the connecting lines (7 to 12), the rest of the areas of the substrate body (2) are removed before the predetermined shaping step.

**Revendications**

1. Procédé pour fabriquer un instrument à mesurer les gradients ou gradiométre à structure tridimensionnelle pour un dispositif à un canal ou à plusieurs canaux servant à la mesure de champs magnétiques ayant des intensités de champ jusqu'au-dessous $10^{-10}$T, en particulier au-dessous de $10^{-12}$T, selon lequel les bobines de gradiomètre supraconductrices (4, 5), situées en différents plans et ayant des dimensions prédéterminées, sont reliées entre elles et sont couplées à au moins un élément supraconducteur d'interférométrie quantique (SQUID), par des lignes de liaison supraconductrices (7 à 10), caractérisé en ce que, tout d'abord, on applique les bobines de gradiomètre (4, 5), disposées à distance l'une de l'autre, de même que les lignes de liaison (7 à 10) s'étendant entre elles, sur un substrat souple (2) qui est au moins essentiellement plan et que, ensuite, on courbe le substrat (2) de manière que l'on obtienne la structure de gradiomètre tridimensionnelle.

2. Procédé selon la revendication 1, caractérisé en ce que l'on prévoit un substrat (2) formé d'une feuille, que l'on dispose, ensemble avec les bobines de gradiomètre (4, 5) et les lignes de liaison (7 à 10) sur un support (15) dont la forme est adaptée à la structure de gradiomètre tridimensionnelle.

3. Procédé selon la revendication 2, caractérisé en ce que l'on forme les pistes conductrices des bobines de gradiomètre (4, 5) et des lignes de liaison (7 à 10) sur une feuille (2).

4. Procédé selon la revendication 3, caractérisé en ce que l'on prévoit une feuille (2) d'un matériau qui résiste à la chaleur.

5. Procédé selon la revendication 3 ou 4, caractérisé en ce que l'on prévoit une feuille (2) susceptible d'être soumise aux opérations de traitement de circuits imprimés souples.

6. Procédé selon une des revendications 3 à 5, caractérisé en ce que l'on prévoit une mince feuille en polyimide en tant que substrat (2).

7. Procédé selon une des revendications 1 à 6, caractérisé en ce que l'on forme dans le substrat (2) des fentes ou des entailles (12) qui facilitent ou permettent la conformation préfixée.

8. Procédé selon une des revendications 1 à 7, caractérisé en ce que, avant l'opération de conformation préfixée, on enlève les régions du substrat (2) en dehors des régions (13) portant les pistes conductrices (4, 5) et les lignes de liaison (7 à 12).

FIG 1

FIG 2